# EUROPÄISCHE PATENTSCHRIFT

(11) **EP 0 781 078 B1**
(45) Veröffentlichungstag und Bekanntmachung des Hinweises auf die Patenterteilung: **13.03.2002**
(21) Anmeldenummer: 96118986.7
(22) Anmeldetag: 27.11.1996
(51) Int. Cl.: H05B 41/295, H05B 41/34, H03K 3/57

(54) **Schaltungsanordnung zur Erzeugung von Impulsspannungsfolgen, insbesondere für den Betrieb von dielektrisch behinderten Entladungen**
Circuit for operating dielectric barrier lamps by pulses
Circuit pour alimenter des lampes à barrière diélectrique par impulsions

(30) Priorität: 21.12.1995 DE 19548003
(43) Veröffentlichungstag der Anmeldung: 25.06.1997
(73) Patentinhaber: Patent-Treuhand-Gesellschaft für elektrische Glühlampen mbH, 81543 München (DE)
(72) Erfinder: Huber, Andreas, 82216 Maisach (DE); Veser, Alwin, 80803 München (DE); Hirschmann, Günther, 81735 München (DE)

(56) Entgegenhaltungen:
- EP-A- 0 399 201
- EP-A- 0 417 771
- DE-A- 1 940 030
- DE-A- 3 723 435
- US-A- 4 051 410
- US-A- 4 051 412
- US-A- 4 405 889
- US-A- 4 645 979
- PATENT ABSTRACTS OF JAPAN vol. 095, no. 004, 31.Mai 1995 & JP 07 022191 A (OLYMPUS OPTICAL CO LTD), 24.Januar 1995,

## Beschreibung

### Technisches Gebiet

Die Erfindung betrifft eine elektrische Schaltungsanordnung gemäß dem Oberbegriff des Anspruchs 1.

Derartige Schaltungsanordnungen dienen zum Erzeugen von Impulsspannungsfolgen. Anwendungen sind u.a. das Zünden und Betreiben von Entladungslampen, z.B., im Falle niedriger Impuls-Wiederholfrequenzen, von Blitzlampen.

Insbesondere dient die erfindungsgemäße Schaltungsanordnung dem Betrieb von Entladungslampen bzw. -strahlern mit mindestens einer dielektrisch behinderten Elektrode mittels unipolarer oder zumindest im wesentlichen unipolarer Spannungsimpulse, wie beispielsweise in der WO 94/23442 beschrieben. Diese Betriebsweise verwendet eine im Prinzip unbeschränkte Folge von Spannungsimpulsen die durch Totzeiten voneinander getrennt sind. Entscheidend für die Effizienz der Nutzstrahlungserzeugung sind im wesentlichen die Impulsform sowie die Zeitdauern der Puls- bzw. Totzeiten. Herkömmliche Betriebsweisen für derartige Lampen verwenden hingegen sinusförmige Wechselspannungen.

Dielektrisch behinderte Entladungen weisen im Unterschied zu konventionellen Entladungen, wie sie z.B. üblicherweise für Entladungslampen Verwendung finden, ein zwischen mindestens einer Elektrode angeordnetes Dielektrikum auf. Der Ladungsträgertransport von einer dielektrisch behinderten Elektrode zum ionisierten Gas der Entladungsstrecke erfolgt daher nicht durch einen Leitungsstrom sondern durch einen Verschiebungsstrom. Daraus resultiert eine kapazitive Komponente im elektrotechnischen Ersatzschaltbild einer derartigen Entladung.

### Stand der Technik

Zwar sind Impulsschaltung, z.B. zum Betreiben von Blitzlampen, bereits bekannt. Dabei wird im einfachsten Fall ein Kondensator über einen Widerstand aufgeladen und mittels schnellem Schalter, z.B. einer Funkenstrecke oder einem Thyratron, über die Primärwicklung eines Impulsübertragers entladen. Der dabei in der Sekundärwicklung des Impulstransformators induziert Spannungsstoß zündet die Blitzlampe.

Nachteilig bei derartigen Schaltungsanordnungen ist, daß unerwünschte Strom- und Spannungsschwingungen auftreten können. Dadurch kann sich zum einen die Blitzdauer unerwünscht verlängern oder die Lampe kann auch - aufgrund gekoppelter Schwingungen - mehrmals unkontrolliert zünden. Dies ist insbesondere bei wissenschaftlichen Anwendungen inakzeptabel, die definierte Bedingungen, z.B. bei stroboskopischen Untersuchungen oder beim optischen Pumpen von Substanzen, voraussetzen. Zum andern können durch die dabei auftretende Spannungs- bzw. Stromumkehr auch elektrische Bauteile, z.B. Kondensatoren übermäßig belastet und folglich die Lebensdauer der Schaltung verkürzt werden.

Der geschilderten Problematik versucht man durch eine sorgfältige Abstimmung von Lampe und Schaltungsanordnung zu begegnen. Ziel ist es dabei, den im wesentlichen durch die Kapazität und Induktivität der Anordnung gebildeten Schwingkreis mit dem Plasmawiderstand der Gasentladung der gezündeten Blitzlampe zu bedämpfen. Im Idealfall (aperiodischer Grenzfall) läßt sich so ein, falls gewünscht auch repetitiver Strom- bzw. Spannungsimpuls ohne störende Schwingungen realisieren.

Dieser Ansatz versagt allerdings bei Entladungsanordnungen mit dielektrisch behinderten Elektroden, da die Impedanz dieser Anordnung im wesentlichen als Kapazität wirkt oder zumindest einen großen kapazitiven Anteil aufweist. Dadurch schwingt die Spannung an den Lampenelektroden hochfrequent und reduziert gemäß der Lehre der WO 94/23442 den Wirkungsgrad der Lampe drastisch.

### Darstellung der Erfindung

Der Erfindung liegt die Aufgabe zugrunde, den genannten Nachteil zu beseitigen und eine Schaltungsanordnung anzugeben, mit deren Hilfe sich weitgehend unipolare Impulsspannungsfolgen mit geringen Schaltungsverlusten erzeugen lassen. Außerdem sollen Impulsspannungsfolgen mit möglichst glatten Impulsformen, insbesondere auch an überwiegend kapazitiv wirkenden Lasten realisierbar sein.

Diese Aufgabe wird erfindungsgemäß durch die kennzeichnenden Merkmale des Anspruchs 1 gelöst. Weitere vorteilhafte Merkmale und Ausführungsformen der Erfindung sind in den Unteransprüchen erläutert.

Die Grundschaltung der Erfindung besteht aus einem Ladekreis, einem Entladekreis und einem Puls- und Rückspeisekreis.

Der Ladekreis besteht, wie an sich bekannt, aus einer Serienschaltung einer Ladeimpedanz und eines Ladekondensators, die mit einer Eingangsspannung verbunden ist. Bevorzugt ist die Ladeimpedanz als Spule realisiert. Der Vorteil gegenüber einem Ohmschen Widerstand als Ladeimpedanz ist zum einen die geringere Verlustleistung. Zum anderen läßt sich durch geeignete Dimensionierung von Ladespule und Ladekondensator eine Resonanzüberhöhung der Spannung am Ladekondensator bezüglich der Eingangsspannung erzielen. Dies ist ggf. bei Lasten mit hohem Spannungsbedarf von Vorteil.

Der Entladekreis umfaßt den Ladekondensator, ein erstes elektrisches Stromventil, z.B. eine Halbleiterdiode, die Primärwicklung eines Impulsübertragers sowie einen schnellen Schalter, bevorzugt einen Transistor, insbesondere einen IGBT (Insulated Gate Bipolar Transistor). Die Primärwicklung und der Schalter sind seriell miteinander verbunden. Die Serienschaltung ist ihrerseits parallel zum Ladekondensator geschaltet. Wenn der Ladekondensator sein Spannungsmaximum erreicht hat, wird der Schalter geschlossen. Daraufhin entlädt sich der Ladekondensator über das Stromventil in die Primärwicklung des Impulsübertragers. Das Stromventil verhindert ein Zurückschwingen der Energie vom Impulsübertrager bzw. der daran angeschlossenen Last auf den Ladekondensator. Wenn der Ladekondensator vollständig entladen ist, wird der Schalter verlustleistungslos geöffnet, und der Ladekondensator wird über die Ladespule erneut aufgeladen.

Der Puls- und Rückspeisekreis umfaßt die Sekundärwicklung des Impulsübertragers, die mit der Sekundärwicklung verbundene Last, z.B. eine Entladungslampe mit dielektrisch behinderten Elektroden, und ein mit einem Pol der Sekundärwicklung einerseits sowie mit einem Rückspeisepunkt andererseits verbundenes Rückspeise-Stromventil, z.B. eine Halbleiterdiode.

Der Rückspeisepunkt ist so gewählt, daß sich in diesem Punkt die von der Last zurückschwingende Energie einspeisen läßt. Dazu dient der Eingang einer mit dem Bezugspotential verbundenen Rückspeise-Energieaufnahmeschaltung. Als Bezugspotential eignet sich z.B. Massepotential. Bei Verwendung eines steuerbaren Halbleiterschalters, beispielsweise eines Transistors als schnellem Schalter, ist dieser vorteilhaft ebenfalls mit Massepotential verbunden. Dies vereinfacht den Aufwand der Beschaltung des entsprechenden Steueranschlußes (z.B. des Basis- bzw. Gateanschlußes), da sich Steuerbeschaltung und Halbleiterschalter auf das gemeinsame Massepotential beziehen. Darüber hinaus ist diese Art der Steuerbeschaltung relativ wenig störanfällig. Als Bezugspotential der Impulsfolge am Ausgang des Impulsübertragers wird das Massepotential festgelegt, indem je ein Pol der Primär- und Sekundärwicklung ebenfalls mit Massepotential verbunden ist.

Während der Schalter geschlossen ist, wird die Energie des Ladekondensators mit Hilfe des Impulsübertragers zur angeschlossenen Last übertragen. Die vom Impulsübertrager und von der Last zurückschwingende Energie passiert das Rückspeise-Stromventil, wird in den Rückspeisepunkt eingespeist und von der Rückspeise-Energieaufnahmeschaltung aufgenommen. Dadurch wird während der Rückschwingphase das Potential des "heißen" Pols der Sekundärwicklung auf das Potential des Rückspeisepunktes geklemmt.

Die Rückspeise-Energieaufnahmeschaltung beinhaltet entweder ein Speicherelement, z.B. einen die zurückschwingende Energie speichernden Kondensator, oder ein Wandlerbauelement, welches die zurückschwingende elektrische Energie in eine andere Energieform, z.B. Wärme umwandelt. Als dissipatives Wandlerbauelement eignet sich im einfachsten Fall ein gegen das Bezugspotential, z.B. Masse geschalteter Ohmscher Widerstand. Nachteilig bei dieser Lösung ist die Beeinflussung des Rückspeisepotentials aufgrund des Spannungsabfalls am Widerstand.

In einer besonders bevorzugten Ausführung ist der Pufferkondensator parallel zum Eingang der Schaltungsanordnung geschaltet. Dadurch wird der Rückspeisepunkt auf das vorteilhaft konstante Eingangspotential gelegt. Ein weiterer Vorteil dieser Maßnahme ist, daß die rückgespeiste Energie für den Ladevorgang des Ladekondensators mit verwendet wird. Deshalb ist dem Pufferkondensator in diesem Fall kein Widerstand als Wandlerbauelement parallel geschaltet. Der Pufferkondensator dient vielmehr als Zwischenspeicher für die zurückschwingende Energie. Ein zwischen Pufferkondensator und Ladespule geschaltetes Stromventil, z.B. eine Halbleiterdiode verhindert ein Rückschwingen der Energie aus dem Ladekondensator.

### Beschreibung der Zeichnungen

Die Erfindung wird im folgenden anhand eines Ausführungsbeispiels näher erläutert. Es zeigen
- Fig. 1: ein Schaltbild der erfindungsgemäßen Schaltungsanordnung für den Betrieb einer Lampe,
- Fig. 2a: eine grafische Darstellung der an den Elektroden der Lampe aus Figur 1 gemessenen Spannung als Funktion der Zeit,
- Fig. 2b: eine grafische Darstellung des zur Spannung aus Figur 2a gehörenden Rückspeisestroms im gleichen Zeitmaßstab.

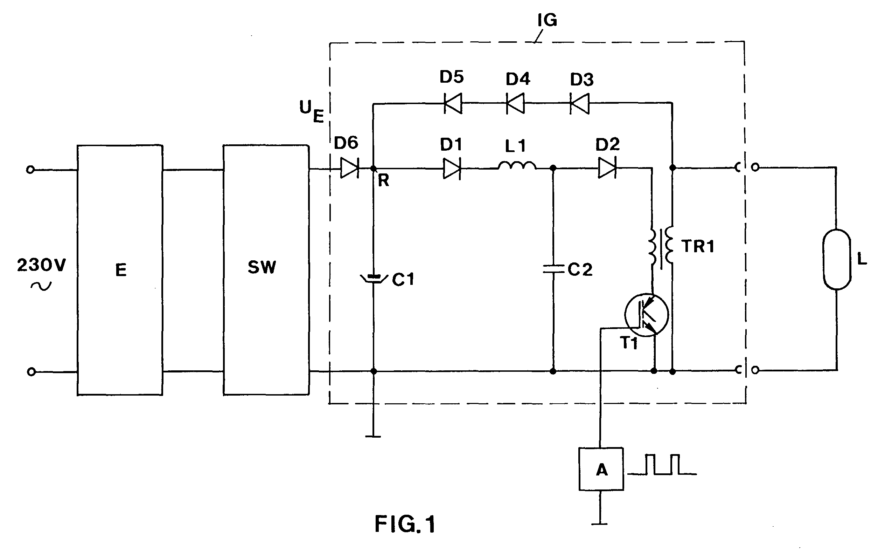

In Figur 1 ist ein Schaltbild einer Anordnung zum Betreiben einer Entladungslampe L mit dielektrisch behinderten Elektroden und einer Leistung von 20 W an 230 V Netzspannung dargestellt. Die Anordnung besteht aus den folgenden Funktionsblöcken: einem Eingangsteil E, einem nachfolgenden Sperrwandler SW, einem nachfolgenden Impulsgenerator IG und einer Ansteuerschaltung A. Der Impulsgenerator IG (in Figur 1 durch eine gestrichelte Linie umrandet) stellt die eigentliche Neuerung der Schaltungsanordnung da und wird deshalb nachfolgend besonders ausführlich erläutert. Eingangsteil E, Sperrwandler SW und Ansteuerschaltung A sind in an sich bekannter Weise realisiert und deshalb in Figur 1 lediglich durch Funktionsblöcke schematisiert.

Das Eingangsteil E enthält eine Funkentstör- und Gleichrichterschaltung und wird von der 230 V Netzspannung gespeist.

Der nachfolgende Sperrwandler SW dient als aktives Oberwellenfilter mit Leistungsregelung. Die Vorteile sind die Einhaltung der vorgeschriebenen Grenzwerte für den Leistungsfaktor und die Netzstromoberwellen einerseits sowie die Leistungskonstanz der Lampe bei Netzspannungsschwankungen andererseits. Bei einer Netzspannungsschwankung im Bereich zwischen 195 V und 253 V ändert sich die Lampenleistung nur um 0,2 W. Bezogen auf die nominelle Leistungsaufnahme der Lampe von 20 W entspricht dies einer Leistungsvariation von 1 %. Ein weiteres wichtiges Argument für das Vorschalten des Sperrwandlers SW ist die für den Impulsgenerator IG maximal zulässige Eingangsspannung (entspricht dem Potential am Rückspeisepunkt bezüglich Masse) von 200 V. Diese Forderung basiert auf der besonders effizienten Betriebsweise der Lampe, die zwischen den Spannungsimpulsen eine Gegenspannung von höchstens 200 V toleriert.

Die Ansteuerschaltung A beinhaltet im wesentlichen einen Rechteckgenerator zur Ansteuerung des im Impulsgenerator IG als schneller Schalter dienenden IGBT's T1 (IGBT: Insulated Gate Bipolar Transistor). Die Ansteuerimpulse werden mit Hilfe eines niederohmigen Treibers, der z.B. in dem Buch von W. Hirschmann und A. Hauenstein "Schaltnetzteile", Verlag Siemens AG, 1990, S. 177, Bild 4.98d beschrieben ist, dem Gate des IGBT's zugeführt. Auf diese Weise werden die steilen Schaltflanken erzielt, die zur Minimierung der Schaltverluste im IGBT erforderlichen sind.

Als Ladekreis des Impulsgenerators IG fungieren ein Pufferkondensator C1, der parallel zum Eingang geschaltet ist, und eine dazu parallel geschaltete Serienschaltung einer Diode D1, einer Ladespule L1 und eines Ladekondensators C2. Für eine Lampenleistung von 20 W wurde für den Ladekondensator ein idealer Wert von 15 nF ermittelt. Für eine angestrebte Nachladezeit von 20 µs folgt daraus für die Ladespule eine Induktivität von ca. 3 mH.

Der Entladekreis des Impulsgenerators IG ist durch eine parallel mit dem Ladekondensator C2 verbundene Reihenschaltung, bestehend aus einer Diode D2 mit der Primärwicklung eines Impulsübertragers TR1 und einem IGBT T1, vervollständigt.

Der Puls- und Rückspeisekreis des Impulsgenerators IG umfaßt die Sekundärwicklung des Impulsübertragers TR1, eine als Last fungierende und mit der Sekundärwicklung verbundene 20 W Lampe L mit dielektrisch behinderten Elektroden, drei in Serie geschaltete und als Rückspeise-Stromventil fungierende Rückspeisedioden D3-D5 sowie den hier als Rückspeise-Energieaufnahmeschaltung fungierende Pufferkondensator C1.

Der Impulsübertrager TR1 weist einen Spulenkörper mit sechs Kammern auf. Die Primärwicklung ist auf eine erste Kammer gewickelt. Die Sekundärwicklung ist auf die restlichen fünf Kammern aufgeteilt. Bei einer Spitzenspannung auf der Sekundärseite von 4 kV ist damit die maximale Spannung pro Kammer auf 800 V begrenzt. Durch die Trennung von Primär- und Sekundärwicklung in unterschiedliche Kammern ergibt sich aufgrund der loseren Kopplung vorteilhaft eine glattere Impulsform. Je ein Pol der Primär- und Sekundärwicklung sind miteinander und mit der Schaltungsmasse als Bezugspotential verbunden. Der Wickelsinn des Impulsübertragers ist so ausgeführt, daß an den Lampenelektroden negative Spannungsimpulse bezüglich Masse erzeugt werden. Die wesentlichen Größen des Impulsübertragers TR1 sind in der folgenden Tabelle zusammengestellt.

**Tabelle 1:**

| Spezifikationen des Impulsübertragers TR1. | | |
|---|---|---|
| Kernmaterial: | N87 (Fa. Siemens) | |
| Wicklung | Primär | Sekundär |
| Anzahl Kammern | 1 | 5 |
| Windungszahl | 20 | 230 |
| Litze | 20·0,1 | 30·0,04 |
| Induktivität | 110 µH | 14 mH |

Der Grund für die Realisierung des Rückspeise-Stromventils durch drei serielle Rückspeisedioden D3 - D5 mit Sperrspannungen von jeweils 2 kV ist die dadurch realisierte Aufteilung der für die Lampe L erforderlichen Spannungsspitzen von ca. 4 kV. Die Serienschaltung D3 - D5 ist einerseits mit dem "heißen" Pol der Sekundärwicklung des Impulsübertrager TR1 und andererseits mit dem als Rückspeisepunkt R wirkenden Verbindungspunkt zwischen Pufferkondensator C1 und erster Diode D1 verbunden. Dadurch wird während der Rückschwingphasen das Potential des "heißen" Pols der Sekundärwicklung auf das Potential des Rückspeisepunktes, d.h. der Ausgangsspannung U_{E} des vorgeschalteten Sperrwandlers geklemmt (ca. 200 V). Eine weitere Diode D6 verhindert ein Abfließen des Rückspeisestroms in den Ausgang des vorgeschalteten Sperrwandlers SW.

Während der Leitendphasen des IGBT's T1 wird jeweils die Energie des Ladekondensators C2 mit Hilfe des Impulsübertragers zur angeschlossenen Lampe L übertragen. Die von der Lampe L reflektierte und im Impulsübertrager TR1 gespeicherte Energie wird über die Rückspeisedioden D3 - D5 in den Pufferkondensator C1 eingespeist und steht danach während der Ladezyklen dem Ladekondensator C2 zur Verfügung.

Die für den Impulsgenerators IG aus Figur 1 verwendeten Bauteile sind in der folgenden Tabelle zusammengestellt.

**Tabelle 2:**

| Liste der für den Impulsgenerator IG aus Figur 1 verwendeten Bauelemente. | |
|---|---|
| C1 | 47 µF |
| C2 | 15 nF |
| D1 | UF 4007 |
| D2 | 1N4936 |
| D3 | BYT01 400 |
| D4 -D6 | RGP02-20E |
| L1 | 3 mH |
| T1 | GB 30U |
| TR1 | s. Tabelle 1 |

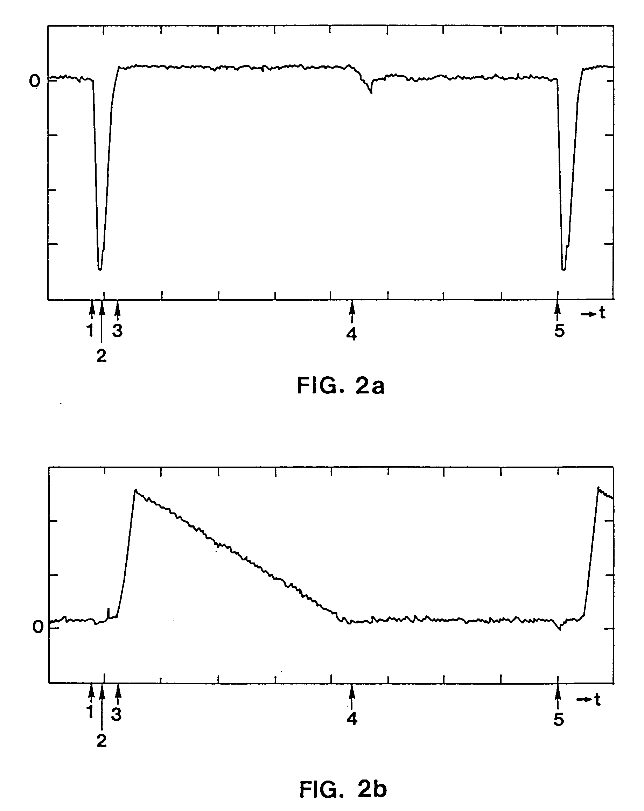

Die beiden Figuren 2a und 2b zeigen Ausschnitte der Zeitverläufe (die fortschreitende Zeit entspricht der positiven Richtung der x-Achse) der an den Elektroden der Lampe L aus Figur 1 gemessenen Spannung bzw. des zugehörigen Rückspeisestroms (jeweils y-Achse) durch die Dioden D3 - D5. Zum Zeitpunkt 1 nimmt die Spannung zwischen den Elektroden (Fig. 2a), beginnend bei ca. 0 V rasch zu, erreicht nach ca. 0,5 µs zum Zeitpunkt 2 ihren Maximalwert von ungefähr -3,5 kV und fällt anschließend ähnlich rasch ab. Zum Zeitpunkt 3 hat die Spannung bereits ihren Nullwert durchschritten und bleibt bis zum Zeitpunkt 4 auf die Spannung am Eingang des Impulsgenerators IG (ca. 200 V) geklemmt. Danach beträgt die Elektrodenspannung bis zum Zeitpunkt 5 ungefähr 0 V. Die Phase zwischen den Zeitpunkten 1 und 3 entspricht den jeweilige Pulsphasen und dauert ca. 2 µs. Die Totphasen entsprechen jeweils der Dauer zwischen den Zeitpunkten 3 und 5 und betragen jeweils ca. 38 µs. Daraus resultiert schließlich ein gegenseitiger zeitlicher Abstand der jeweiligen Spannungsimpulse von 40 µs, entsprechend einer Pulswiederholfrequenz von 25 kHz.

Zum Zeitpunkt 3 beginnt die Rückschwingphase, erkennbar am steilen Anstieg des Rückspeisestroms (Fig. 2b). Der Rückspeisestrom beginnt mit einem Wert von 0 A und fällt nach Erreichen eines Maximums linear auf den anfänglichen Wert - der zum Zeitpunkt 4 wieder erreicht wird - zurück. Damit ist die Rückschwingphase beendet.

Der Zeitpunkt 5 entspricht der Situation zum Zeitpunkt 1, und ein neuer Spannungsimpuls beginnt. Die zuvor geschilderten Zyklen für Elektrodenspannung und Rückspeisestrom wiederholen sich solange die Schaltungsanordnung in Betrieb ist.

Die Erfindung ist nicht auf die angegebenen Ausführungsbeispiele beschränkt.

## Patentansprüche

1. Elektrische Schaltungsanordnung zur Erzeugung von Impulsspannungsfolgen, insbesondere für den Betrieb von dielektrisch behinderten Entladungen, mit
- einem Ladekreis, welcher Ladekreis eine an seinen Eingang gekoppelte Serienschaltung aus einer Ladeimpedanz (L1) und einem Ladekondensator (C2) aufweist, wodurch beim Anlegen einer Spannung U_{E} an den Eingang des Ladekreises der Ladekondensator (C2) zunächst auf eine Spannung U_{C} aufgeladen wird,
- einem Entladekreis, der außer dem Ladekondensator (C2) eine Serienschaltung umfaßt, bestehend aus einem elektrischen Entladestromventil (D2), der Primärwicklung eines Impulsübertragers (TR1) sowie einem schnellen steuerbaren Schalter (T1) und einer Ansteuerschaltung (A), die den Schalter (T1) für vorwählbare Zeitdauern alternierend ein- und ausschaltet, wobei die Serienschaltung mit dem Ladekondensator (C2) parallel verbunden ist, wodurch sich der Ladekondensator (C2) bei geschlossenem Schalter (T1) über das Entladestromventil (D2) und die Primärwicklung entlädt,
- einem Pulskreis, der die Sekundärwicklung des Impulsübertragers (TR1) und eine mit dieser Sekundärwicklung verbundene Last, z.B. eine Entladungslampe (L) mit dielektrisch behinderten Elektroden umfaßt,
**dadurch gekennzeichnet, daß** die Schaltungsanordnung zusätzlich einen Rückspeisekreis aufweist, bestehend aus
- einer Rückspeise-Energieaufnahmeschaltung (C1), deren Eingang als Rückspeisepunkt (R) fungiert, und
- einem Rückspeise-Stromventil (D3 - D5), das einerseits mit einem Pol der Sekundärwicklung des Impulsübertragers (TR1) und andererseits mit dem Rückspeisepunkt (R) verbunden ist, wodurch die von der Last (L) und vom Impulsübertrager TR1 zurückschwingende Energie das Rückspeise-Stromventil (D3 - D5) passiert, in den Rückspeisepunkt (R) eingespeist und von der Rückspeise-Energieaufnahmeschaltung (C1) aufgenommen wird, so daß folglich während der Rückschwingphase das Potential des Pols der Sekundärwicklung auf das Potential des Rückspeisepunktes geklemmt wird.

2. Schaltungsanordnung nach Anspruch 1, **dadurch gekennzeichnet, daß** die Rückspeise-Energieaufnahmeschaltung ein elektrisches Speicherbauelement enthält, dessen Hochpunkt mit dem Rückspeise-Stromventil und dessen Fußpunkt mit Bezugspotential verbunden ist und dadurch die zurückschwingende Energie speichert.

3. Schaltungsanordnung nach Anspruch 2, **dadurch gekennzeichnet, daß** das elektrische Speicherbauelement als Kondensator realisiert ist.

4. Schaltungsanordnung nach Anspruch 1, **dadurch gekennzeichnet, daß** die Rückspeise-Energieaufnahmeschaltung ein elektrisches Wandlerbauelement enthält, dessen Hochpunkt mit dem Rückspeise-Stromventil und dessen Fußpunkt mit Bezugspotential verbunden ist und dadurch die zurückschwingende elektrische Energie im Wandlerbauelement in eine andere Energieform umgewandelt wird.

5. Schaltungsanordnung nach Anspruch 4, **dadurch gekennzeichnet, daß** das elektrisches Wandlerbauelement als Widerstand realisiert ist, der die zurückschwingende elektrische Energie in Wärme umwandelt.

6. Schaltungsanordnung nach den Ansprüchen 2 und 4, **dadurch gekennzeichnet, daß** Rückspeise-Energieaufnahmeschaltung aus der Parallelschaltung eines Kondensators und eines Widerstandes besteht.

7. Schaltungsanordnung nach Anspruch 2, **dadurch gekennzeichnet, daß** die Rückspeise-Energieaufnahmeschaltung aus einem Kondensator (C1) besteht, dessen Hochpunkt außer mit dem Rückspeise-Stromventil (D3 - D5) zusätzlich über ein Ladestromventil (D1) mit der Ladeimpedanz (L1) verbunden ist, wodurch die rückgespeiste Energie für den Ladevorgang des Ladekondensators (C2) mit verwendet wird, wobei das Ladestromventil (D1) ein Rückschwingen der Energie aus dem Ladekondensator verhindert.

8. Schaltungsanordnung nach Anspruch 1, **dadurch gekennzeichnet, daß** die Ladeimpedanz durch eine Spule (L1) realisiert ist.

9. Schaltungsanordnung nach Anspruch 1, **dadurch gekennzeichnet, daß** die Stromventile durch Halbleiterdioden (D1 - D6) realisiert sind.

10. Schaltungsanordnung nach Anspruch 1, **dadurch gekennzeichnet, daß** der schnelle Schalter durch einen Transistor, insbesondere einen IGBT (T1) (IGBT: Insulated Gate Bipolar Transistor) realisiert ist.

11. Schaltungsanordnung nach Anspruch 1, **dadurch gekennzeichnet, daß** je ein Pol der Primär- und der Sekundärwicklung des Impulsübertragers (TR1) miteinander und mit dem Bezugspotential der Schaltungsanordnung verbunden sind.

## Claims

1. Electric circuit arrangement for generating pulse voltage trains, in particular for operating dielectrically impeded discharges, having
- a charging circuit, which charging circuit has a series circuit, coupled to its input, consisting of a charging impedance (L1) and a charging capacitor (C2), as a result of which the charging capacitor (C2) is firstly charged to a voltage U_{C} upon the application of a voltage U_{E} to the input of the charging circuit,
- a discharging circuit which, apart from the charging capacitor (C2), comprises a series circuit consisting of an electric discharging current valve (D2), the primary winding of a pulse transformer (TR1), as well as a fast controllable switch (T1) and a driving circuit (A) which alternately switches the switch (T1) on and off for preselectable time periods, the series circuit being connected in parallel with the charging capacitor (C2), as a result of which the charging capacitor (C2) discharges via the discharging current valve (D2) and the primary winding in the event of a closed switch (T1),
- a pulse circuit which comprises the secondary winding of the pulse transformer (TR1) and a load connected to this secondary winding, for example a discharge lamp (L) with dielectrically impeded electrodes,
**characterized in that** the circuit arrangement additionally has a feedback circuit consisting of
- a feedback energy absorption circuit (C1) whose input functions as feedback point (R) and
- a feedback current valve (D3-D5) which is connected, firstly, to a pole of the secondary winding of the pulse transformer (TR1) and, secondly, to the feedback point (R),
as a result of which the oscillating energy returning from the load (L) and from the pulse transformer (TR1) passes the feedback current valve (D3-D5), is fed into the feedback point (R) and is picked up by the feedback energy absorption circuit (C1) such that consequently the potential of the pole of the secondary winding is clamped during the returning oscillating phase at the potential of the feedback point.

2. Circuit arrangement according to Claim 1, **characterized in that** the feedback energy absorption circuit contains an electric memory component whose high end is connected to the feedback current valve and whose low end is connected to reference potential and thereby stores the returning oscillating energy.

3. Circuit arrangement according to Claim 2, **characterized in that** the electric memory component is implemented as a capacitor.

4. Circuit arrangement according to Claim 1, **characterized in that** the feedback energy absorption circuit contains an electric transducer component whose high end is connected to the feedback current valve and whose low end is connected to reference potential, the returning oscillating electric energy thereby being converted in the transducer component into another form of energy.

5. Circuit arrangement according to Claim 4, **characterized in that** the electric transducer component is implemented as a resistor which converts the returning oscillating electric energy into heat.

6. Circuit arrangement according to Claims 2 and 4, **characterized in that** the feedback energy absorption circuit comprises the parallel circuit of a capacitor and a resistor.

7. Circuit arrangement according to Claim 2, **characterized in that** the feedback energy absorption circuit consists of a capacitor (C1) whose high point is additionally connected, apart from to the feedback current valve (D3-D5), to the charging impedance (L1) via a charging current valve (D1), as a result of which the fed back energy is also used for the charging operation of the charging capacitor (C2), the charging current valve (D1) preventing returning oscillation of the energy from the charging capacitor.

8. Circuit arrangement according to Claim 1, **characterized in that** the charging impedance is implemented by a coil (L1).

9. Circuit arrangement according to Claim 1, **characterized in that** the current valves are implemented by semiconductor diodes (D1-D6).

10. Circuit arrangement according to Claim 1, **characterized in that** the fast switch is implemented by a transistor, in particular an IGBT (T1) (IGBT: Insulated Gate Bipolar Transistor).

11. Circuit arrangement according to Claim 1, **characterized in that** one pole each of the primary and secondary windings of the pulse transformer (TR1) are connected to one another and to the reference potential of the circuit arrangement.

## Revendications

1. Circuit électrique de production de trains d'impulsions de tension, notamment pour l'alimentation de décharges à barrière diélectrique, comprenant :
- un circuit de charge, lequel comporte, couplé à son entrée, un circuit série constitué d'une impédance (L1) de charge et d'un condensateur (C2) de charge, grâce à quoi, lorsqu'une tension U_{E} est appliquée à l'entrée du circuit de charge, le condensateur (C2) de charge est d'abord chargé jusqu'à une tension U_{C},
- un circuit de décharge, qui comprend, outre le condensateur (C2) de charge, un circuit série constitué d'une soupape (D2) électrique de courant de décharge, de l'enroulement primaire d'un transformateur (TR1) d'impulsions, ainsi que d'un interrupteur (T1) qui peut être commandé rapidement et d'un circuit (A) de commande qui ferme et ouvre en alternance l'interrupteur (T1) pendant des laps de temps qui peuvent être prescrits, le circuit série étant relié en parallèle avec le condensateur (C2) de charge de sorte que le condensateur (C2) de charge se décharge lorsque l'interrupteur (T1) est fermé par l'intermédiaire de la soupape (D2) de courant de décharge et de l'enroulement primaire,
- un circuit d'impulsion, qui comprend l'enroulement secondaire du transformateur (TR1) d'impulsions et une charge reliée à cet enroulement secondaire, par exemple une lampe (L) de décharge ayant des électrodes à barrière diélectrique,
**caractérisé en ce que** le circuit comprend en outre un circuit d'alimentation de retour constitué,
- d'un circuit (C1) d'absorption d'énergie et d'alimentation de retour, dont l'entrée sert de point (R) d'alimentation de retour, et
- d'une soupape (D3 à D5) de courant d'alimentation de retour, qui est reliée, d'une part, à un pôle de l'enroulement secondaire du transformateur (TR1) d'impulsions et, d'autre part, au point (R) d'alimentation de retour,
grâce à quoi l'énergie oscillant par la charge (L) et par le transformateur (TR1) d'impulsions passe la soupape (D3 à D5) de courant d'alimentation de retour, est injectée au point (R) d'alimentation de retour et est absorbée par le circuit (C1) d'absorption d'énergie et d'alimentation de retour, de sorte que, pendant la phase d'oscillation en retour, le potentiel du pôle de l'enroulement secondaire est fixé au potentiel du point d'alimentation de retour.

2. Circuit suivant la revendication 1, **caractérisé en ce que** le circuit d'absorption d'énergie et d'alimentation de retour comporte un composant électrique d'emmagasinage, dont le point haut est relié à la soupape de courant d'alimentation de retour et dont le pied est relié au potentiel de référence, et qui emmagasine ainsi l'énergie oscillante de retour.

3. Circuit suivant la revendication 2, **caractérisé en ce que** le composant électrique d'emmagasinage est réalisé sous la forme d'un condensateur.

4. Circuit suivant la revendication 1, **caractérisé en ce que** le circuit d'absorption d'énergie et d'alimentation de retour comporte un composant électrique convertisseur, dont le point haut est relié à la soupape de courant d'alimentation et de retour et dont le pied est relié au potentiel de référence, et qui convertit ainsi l'énergie électrique d'oscillation de retour dans le composant convertisseur en une autre forme d'énergie.

5. Circuit suivant la revendication 4, **caractérisé en ce que** le composant électrique convertisseur est réalisé sous la forme d'une résistance qui transforme en chaleur l'énergie électrique d'oscillation de retour.

6. Circuit suivant les revendications 2 et 4, **caractérisé en ce que** le circuit d'absorption d'énergie et d'alimentation de retour est constitué du circuit parallèle d'un condensateur et d'une résistance.

7. Circuit suivant la revendication 2, **caractérisé en ce que** le circuit d'absorption d'énergie et d'alimentation de retour est constitué d'un condensateur (C1) dont le point haut est relié, outre à la soupape (D3 à D5) de courant d'alimentation de retour, de plus, par une soupape (D1) de courant de charge, à l'impédance (L1) de charge, grâce à quoi l'énergie d'alimentation de retour est utilisée pour l'opération de charge du condensateur (C2) de charge, la soupape (D1) de courant de charge empêchant toute oscillation en retour de l'énergie provenant du condensateur de charge.

8. Circuit suivant la revendication 1, **caractérisé en ce que** l'impédance de charge est réalisée par une bobine (L1).

9. Circuit suivant la revendication 1, **caractérisé en ce que** les soupapes de courant sont réalisées par des diodes (D1 à D6) à semiconducteurs.

10. Circuit suivant la revendication 1, **caractérisé en ce que** l'interrupteur rapide est réalisé par un transistor, notamment par un IGBT (T1) (IGBT : Insulated Gate Bipolar Transistor).

11. Circuit suivant la revendication 1, **caractérisé en ce que**, respectivement, un pôle de l'enroulement primaire et un pôle de l'enroulement secondaire du transformateur (TR1) d'impulsions sont reliés entre eux et au potentiel de référence du circuit.
